# EUROPEAN PATENT APPLICATION

(11) **EP 2 466 320 A2**
(43) Date of publication of application: **20.06.2012**
(21) Application number: 11191067.5
(22) Date of filing: 29.11.2011
(51) Int. Cl.: G01R 27/18, G01R 31/40

(54) **Measuring the electrical insulation resistance of a DC voltage source**

(30) Priority: 17.12.2010 ES 201031881
(71) Applicant: Zigor Corporación, S.A., 01013 Vitoria Alava (ES)
(72) Inventor: Beltza Igoa, Aitor, 31820 Etxarri-Aranatz (Navarra) (ES); Corera Casty, Santiago, 20017 Donostia (Guipúzcoa) (ES); Ibabe Aranguren, Aitor, 20570 Bergera (Guipúzcoa) (ES); Iribarren Asenjo, José Luis, 01013 Vitoria (Alava) (ES)
(74) Representative: Novagraaf Technologies

(57) **Abstract**

A process for measuring the electrical insulation resistance of a dc voltage source, such as a panel of photovoltaic cells or other device for generating direct electrical current, in which the dc voltage source is exposed simultaneously, in common mode, to at least two electrical voltage to earth values.

## Description

### FIELD OF THE INVENTION

This invention relates to a process and a device for measuring the electrical insulation resistance to earth of a dc voltage source of any type, very particularly of photovoltaic installations.

### BACKGROUND OF THE INVENTION

In an electrical installation an insulation fault with respect to earth means that a fault electrical current, of a value dependent on the current source, may flow through the fault site. Depending on the value of this current, the consequences for the safety of the installation may be considerable, not only for the installation but also for people, including the risk of fire.

Electrical installations may be insulated from earth (resistance to earth must be as high as possible) or connected to earth (resistance to earth must be as low as possible).

Each installation has a set potential to earth and must be insulated from earth as well as possible to prevent the currents which flow from the installation over the surface of the earth from constituting a hazard due to a defect or malfunctioning of the insulation.

In electrical installations the insulation resistance (Rᵢₙₛᵤₗₐₜᵢₒₙ, hereinafter Rᵢ) is the value which determines safety and for this reason in installations such as photovoltaic installations it is essential to monitor the state of deterioration of the insulation.

Consequently, various national and international standards have been drawn up for low voltage installations which stipulate how best to protect against insulation faults.

These include:
- **Spanish Royal Decree 842/2002** Low voltage regulation
- **Spanish Royal Decree 1663/2000** Connection of photovoltaic installations to the low voltage grid
- **IDAE (PCT-A)** Technical specifications for installations insulated from the grid (IDAE = Spanish Institute for Energy Diversification and Saving)
- **IDAE (PCT-A)** Technical specifications for installations connected to the grid
- **IEC 60364-7-712** Electrical installations in buildings.
- **IEC TS 62257-7-1:2006-12** Technical specifications; recommendations for small renewable energy and hybrid systems for rural electrification
- **IEC 62257-5:2005-07** Technical specifications; recommendations for small renewable energy and hybrid systems for electrification
- **IEC 62109-1 Ed.1: IEC 62109-1** Safety of power converters for use in photovoltaic power systems
- **IEC 62109-2 Ed.1:** Safety of power converters for use in photovoltaic power systems.

As a result of all these standards, it is necessary to measure the Rᵢₙₛᵤₗₐₜᵢₒₙ in solar photovoltaic installations before connecting them.

In this context, it should be borne in mind that in a photovoltaic installation, as in any other installation generating dc voltage, all the components contribute to a reduction in Rᵢ and determination of the value thereof is going to be a function of the measurement algorithm. In all cases the standard stipulates that this variable be measured before connection to the grid. Hereinafter, we shall focus especially on the particular case of photovoltaic installations, it being understood that any other installations generating direct electrical current are not excluded.

Nowadays various methods are known which have been developed for measuring Rᵢ before connection to the grid. These include monitoring fault current by means of a fault current tracer unit sensitive to any type of current leakage; this unit is known as an RCMU, an acronym standing for Residual Current Monitoring Unit. However, leakage current is not only due to insulation resistance but also to the earth capacitance of the elements of the installation. Leakage current measurement therefore does not correspond to leakage resistance, which moreover may vary over time such that the insulation deteriorates over the course of operation. In this respect, reference is made to insulation measuring systems based on variable clock pulses.

### EXPLANATION OF THE INVENTION AND ADVANTAGES

In the light of this situation, the present invention relates to a method and device allowing measurement of insulation resistance to earth in direct current generating installations, such as arrays of photovoltaic solar cells; that is to say the patent applies to the measurement of Rᵢ in photovoltaic installations, not only prior to connection, but also during operation of the system through continuous measurement thereof.

This invention provides a process for measuring the electrical insulation resistance of a dc voltage source, such as a panel of photovoltaic cells or other device for generating direct electrical current, characterised in that the dc voltage source is exposed, in common mode, to at least two electrical voltage to earth values; transducers are used to measure the current intensities corresponding to the two common mode electrical voltage to earth values for the dc voltage source in question; by means of an analog-digital converter, said voltage and intensity values are acquired by a computer which, in accordance with a given algorithm, obtains an insulation resistance value; said computer ensures that acquisition of the voltage and intensity values takes place in real time; said computer controls the moment of acquisition of the voltage and intensity values, since it controls the opening and closing of switches which distinguish the circuit which at each moment is exposed to a common voltage to earth value, or indeed by means of constant clock pulse sources; the computer acquires the voltage and intensity values with a certain delay with regard to the change from one to the other common voltage to earth value, ensuring that the system has reached steady operating conditions.

To apply this process, the device of the invention consists of an electronic unit known as an insulation sensor which has a connection to earth and to one or more dc voltage generating systems, and whose insulation sensor includes one or more transducers for measuring current intensity and/or voltage, and a computer of the microprocessor type or the like.

The principle for carrying out measurement of the Rᵢ consists in exposing the object whose insulation resistance to earth it is desired to measure to at least two levels of common mode voltage to earth. From the two levels of voltage, transducers measure the resultant current intensities corresponding to each common mode voltage in a given branch of the installation in question. The voltage and current values are acquired by the computer (prior analog-digital converter) which processes them mathematically to obtain the insulation resistance value. This computer controls acquisition of the voltage and current values in real time and controls the system for common voltage variation whether using switches or using a pulse source, to ensure that the measurements are not simultaneous for both voltage values.

The method requires the acquisition of voltage and current data to take place with delay with regard to the moment of common mode voltage change. This time is a set value and depends not only on the insulation resistance but also on the electrical capacitance to earth of the elements of the installation; the value of this delay is set so as to ensure that the system arrives at a point close to steady operating conditions and that transient conditions are eliminated before the measurements are taken.

A voltage value is always required which is not relevant yet really necessary for calculating the intended insulation resistance value, which is why different configurations with different dc sources may be used. The electrical capacitance to earth (capacitor) of the object whose leakage resistance it is desired to measure is also considered.

In accordance with a variant embodiment, said insulation sensor has: a plurality of electronic two-way switches, first and second, which are interposed between the connection to earth and the connections to said systems for generating dc voltage; a first voltage transducer connected between an internal or external source for generating dc voltage and a first analog-digital voltage converter; a first intensity transducer connected between a resistor through which passes the leakage current and a first analog-digital intensity converter; and a computer which is connected to said first analog-digital voltage converter and first analog-digital intensity converter.

In another variant embodiment, irrespective of other external systems for generating dc voltage, the insulation sensor includes: an auxiliary voltage pulse source with constant clock times, which generates a square voltage wave of a certain frequency determined by the time constants which enable the system to reach its steady operating conditions; a shunt resistor, Rₛₕᵤₙₜ; a second voltage transducer connected between the voltage pulse source and a second analog-digital voltage converter; a second intensity transducer connected between the shunt resistor, Rₛₕᵤₙₜ and a second analog-digital intensity converter; and a computer which is connected to said second analog-digital voltage converter and second analog-digital intensity converter.

The system consists of an electronic device which acts as an insulation sensor for this type of installation. The sensor device may be used in installations with 1 to N dc generating systems which have a common point, without the N systems having to have the same dc energy source, wherein the latter may instead be different, for example photovoltaic panels or arrays among other options.

The sensor may function with different input dc voltage intervals and the measurement result may be read out by conventional methods.

The invention allows measurements of the Rᵢ to be made during operation and not only prior to connection.

Through its configuration and measurement principle, the measurement system is inexpensive and allows highly accurate measurements to be obtained.

### DRAWINGS AND REFERENCE SIGNS

To enable a better understanding of the nature of the invention, the attached drawings show an industrial embodiment which constitutes a solely illustrative, non-limiting example.
Figure 1 shows an electrical diagram illustrating the composition of the insulation sensor device (1) of the invention, in which an assembly of panels of photovoltaic cells (17) is connected at the node N1.
Figure 2 is a diagram similar to that of figure 1, but here the assembly of panels of photovoltaic cells (17) is connected at the node N2.
Figure 3 is similar to preceding figures 2 and 3, but here the assembly of panels of photovoltaic cells (17) is connected between the nodes N1 and N2.
Figure 4 shows an electrical diagram in which the insulation sensor (1) is measuring the Rᵢ of any device for generating direct current, connected to the node N1. This figure includes a diagram of a square wave which exhibits two voltage values v₁ and v₂ at equal intervals plotted on an x-axis relating to time (T). Below this diagram there are another two showing the delay (T_{d}) and the data acquisition time (Tₐ) for v₁ and i₁, and v₂ and i₂, respectively.
Figure 5 is similar to figure 4, but here the assembly of panels of photovoltaic cells (17) is connected at the node N1.

In these figures the following reference signs are used:
- 1: Insulation sensor
- 2: Computer
- 3: First electronic two-way switch
- 4: Second electronic two-way switch
- 5: Dc voltage pulse source
- 6: Shunt resistor Rₛₕᵤₙₜ
- 7: Earth
- 8: First voltage transducer
- 9: First intensity transducer
- 10: First analog-digital voltage converter
- 11: First analog-digital intensity converter
- 12: Second voltage transducer
- 13: Second intensity transducer
- 14: Second analog-digital voltage converter
- 15: Second analog-digital intensity converter
- 16: Supply source
- 17: Panel of photovoltaic cells
- 18: Resistor connected to earth (7)
- N1: Connection node for system generating direct current
- N2: Connection node for system generating direct current
- Rᵢ: Insulation resistance
- V: Supply source voltage (16)
- v₁: Pulse source voltage 1 (5)
- v₂: Pulse source voltage 2 (5)
- i₁: voltage Intensity with first switch closed or for v₁
- i₂: voltage Intensity with second switch closed or for v₂
- T: Time, x-axis
- T_{d}: Delay in measurement acquisition
- Tₐ: Time of measurement acquisition

### DESCRIPTION OF A PREFERRED EMBODIMENT

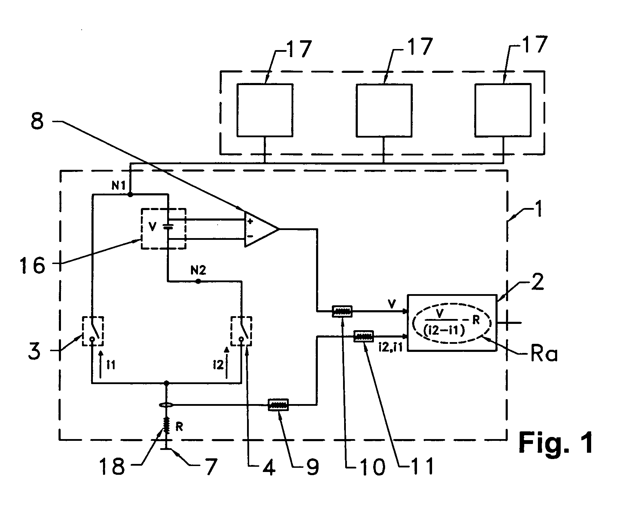

The invention relates to a process and device for measuring Rᵢ to earth (7) in installations of photovoltaic solar cells. With regard to the device, according to the invention said device substantially consists (figure 1) of an electronic unit known as an insulation sensor (1) which has a connection to earth (7) and to one or more systems for generating dc voltage (16, 17), and whose insulation sensor (1) includes one or more transducers (8, 9, 12, 13) for measuring current intensity and/or voltage, a plurality of analog-digital converters (10, 11, 14, 15), and a computer (2) of the microprocessor type or the like.

A preferred embodiment of the invention is illustrated in figures 1, 2 and 3, in which the insulation sensor (1) has: a plurality of electronic two-way switches (3, 4), first and second, which are interposed between the connection to earth (7) and the connections (N1, N2 etc.) to said systems for generating dc voltage (16, 17); a first voltage transducer (8) connected between an internal or external source for generating dc voltage (16, 17) and a first analog-digital voltage converter (10); a first intensity transducer (9) connected between a resistor (18) connected to earth (7) and a first analog-digital intensity converter (11); and a computer (2) which is connected to said first analog-digital voltage converter (10) and first analog-digital intensity converter (11).

This invention provides a process for measuring the electrical insulation resistance of a dc voltage source, such as a panel of photovoltaic cells (17) or other device for generating direct electrical current, characterised in that the direct current source is exposed simultaneously, in common mode, to at least two electrical voltage to earth (7) values; intensity transducers, first (9) and second (13), are used to measure the current intensities (i₁, i₂) corresponding to the two common mode electrical voltage to earth (7) values (v₁, v₂) for the dc voltage source in question (16, 17); by means of a first analog-digital voltage converter (10) and a first analog-digital intensity converter (11), said voltage (v₁, v₂) and intensity (i₁, i₂) values are acquired by a computer (2) which, in accordance with a set algorithm, obtains an insulation resistance value (Rᵢ); said computer (2) ensures that the acquisition of the voltage (v₁, v₂) and intensity values (i₁, i₂) takes place in real time, said computer (2) also controlling the moment of acquisition of the voltage (v₁, v₂) and intensity values (i₁, i₂), since it controls opening and closing of the electronic switches (3, 4) which distinguish the circuit which at each moment is exposed to a common voltage to earth (7) value (v₁, v₂) (which corresponds to the preferred embodiment at present in question), or indeed using constant clock pulse sources (5) (which is the other embodiment referred to below); moreover, said computer (2) acquires the voltage (v₁, v₂) and intensity values (i₁, i₂) with a certain delay with regard to the change from one to the other common voltage to earth (7) value (v₁, v₂), ensuring that the system has reached steady operating conditions.

Then, in the first embodiment, to vary the common mode voltage to earth (7) by means of switches, the following takes place:

The sensor device (1) is connected (figures 1, 2 and 3) on one side to a pole of the dc generating source (16, 17), and on the other to earth (7). The value of V may be obtained from an external supply source or is supplied directly from the photovoltaic cells or arrays, etc.

In this configuration, the device is composed of electronic switches; first (3) and second (4), and one or more of said intensity and voltage transducers (8, 9, 12, 13), more specifically a first voltage transducer (8) and a first intensity transducer (9). The switches (3, 4) carry out the common voltage variation, for which they switch under the control of the computer in such a way as to carry out voltage and current measurements in the circuit. These voltage and current values are managed by applying a set of mathematical equations which allow measurement of the insulation resistance value Rᵢ.

The first (3) and second (4) switches are two-way switches (they may interrupt or allow the passage of current in either direction). The computer (2) controls the opening and closing of the same such that they close alternately and never simultaneously. When the first switch (3) is closed the current i₁ is generated, and when the second switch (4) is closed the current i₂ is generated. The computer (2) reads, observing the corresponding delay, the voltage value and the values i₁ or i₂, depending on whether the first (3) or second (4) switch is closed, and calculates Rᵢ, using the formula: Ri= [V/ (i₂-i₁)] -R

The opening and closing frequency of said switches (3, 4) must be sufficiently low to ensure that the capacitance distributed to earth (7) of the device or devices for which it is desired to know the Rᵢ measurement does not distort the measurement; this frequency is defined by an equation, the variable of which is the measurement error due to the transient charge-discharge conditions of the capacitance distributed to earth (7).

The device will measure the insulation resistance to earth (7) of all the devices connected to the nodes N1 or N2 provided that said devices fulfil the condition of being dc voltage generators, i.e. arrays, photovoltaic panels (17), etc.

V (figures 1, 2 and 3) may be the voltage of any one of the devices of which it is desired to measure the Rᵢ to earth (7), or indeed an insulated voltage generated as a function of the external supply source (16) or of the photovoltaic panels (17), etc.

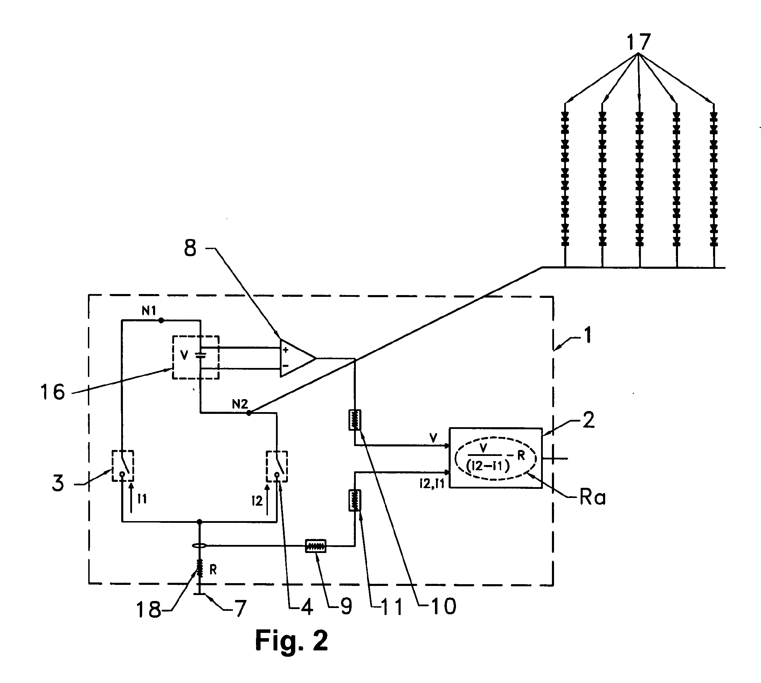

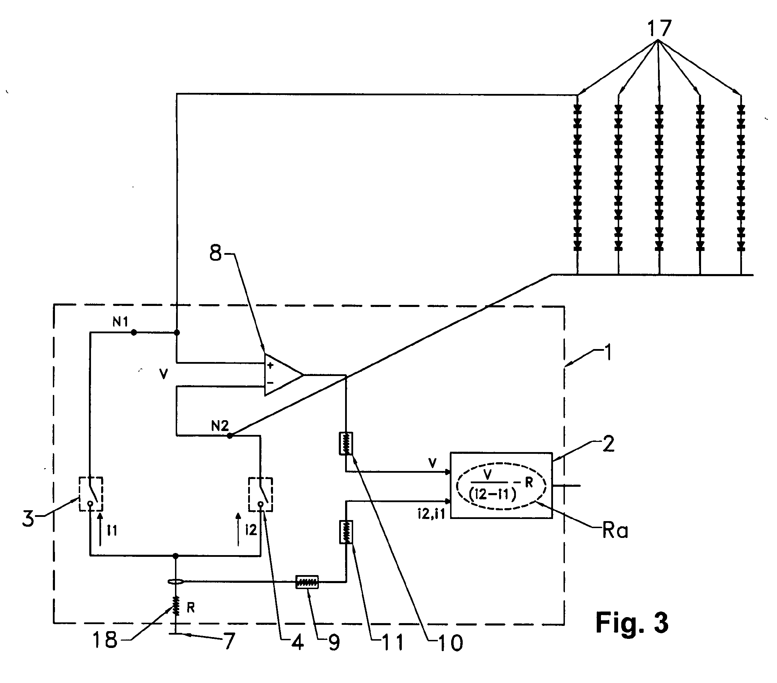

A particular but non-limiting embodiment of this method is shown in figures 2 and 3. Figure 2 shows the configuration in which the voltage value V is obtained from an external supply source (16) as dc source and the photovoltaic panels (17), as the installation of which it is desired to know the value of Rᵢ, are connected in a single branch to the node N1.

Figure 3 shows a configuration in which the voltage value V is obtained from the photovoltaic panels (17) as the direct current source, such that they are connected by both branches to the nodes N1 and N2.

In another variant embodiment, irrespective of other external systems for generating dc voltage, the insulation sensor (1) includes: an auxiliary voltage pulse source (5) with constant clock times, which generates a square voltage wave of a certain frequency determined by the time constants which enable the system to reach its steady operating conditions; a shunt resistor, Rₛₕᵤₙₜ (6); a second voltage transducer (12) connected between the voltage pulse source (5) and a second analog-digital voltage converter (14); a second intensity transducer (13) connected between the shunt resistor, Rₛₕᵤₙₜ (6) and a second analog-digital intensity converter (15); and a computer (2) which is connected to said second analog-digital voltage converter (14) and second analog-digital intensity converter (15).

As has already been said, the insulation sensor (1) may operate with different configurations which use different elements for varying the common mode voltage without being limited in this regard to the use of switches (3, 4), one possible method being the use of an auxiliary voltage pulse generator or source (5) instead of the switches (3, 4) mentioned above.

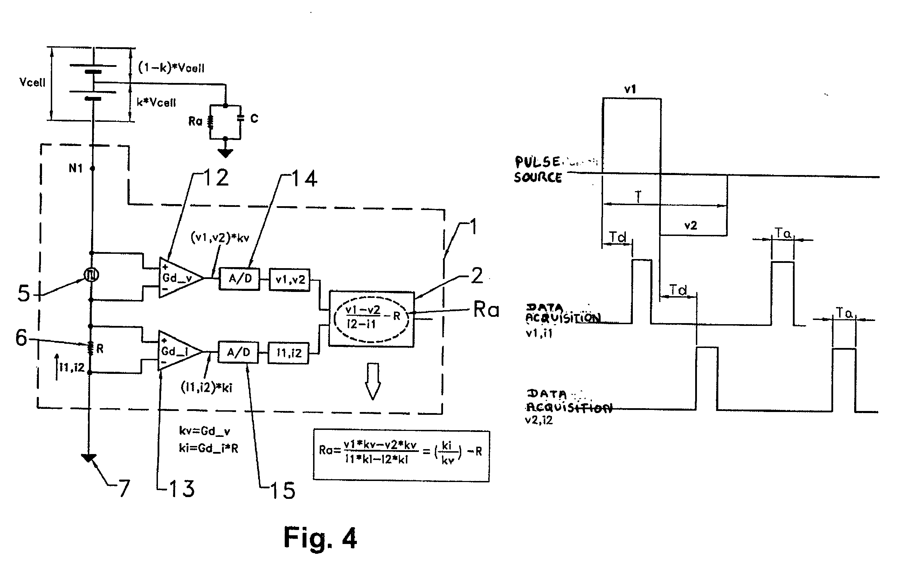

In this respect, figure 4 shows the particular configuration by means of which the resistance Rᵢ to earth (7) is measured of any dc generating device connected to N1.

In this case, the measuring device consists of a second voltage transducer (12) and a second intensity transducer (13). The intensity is measured by means of a shunt resistor, Rₛₕᵤₙₜ (6), the voltage drop allowing the current intensity information sought to be obtained.

The dc voltage pulse source (5) generates a square voltage wave of a frequency determined by the time constants, such that the system arrives at a voltage and current situation close to that of steady operating conditions. The computer (2) measures the current intensity and voltage values corresponding to each pulse (prior adapter as a function of gain and a second analog-digital voltage converter 14 and a second analog-digital intensity converter 15); the insulation resistance will then be: Rᵢ= [(v₁-v₂) / (i₁-i₂)] - Rₛₕᵤₙₜ

The computer (2) controls the dc voltage pulse source (5), specifying the period of time of change from v₁ (to which the value of i₁ corresponds) to v₂ (to which the value of i₂ corresponds), always observing the delay necessary for the system to be close to steady operating conditions and ensuring the data acquisition time necessary for measuring the voltage and current intensity variables.

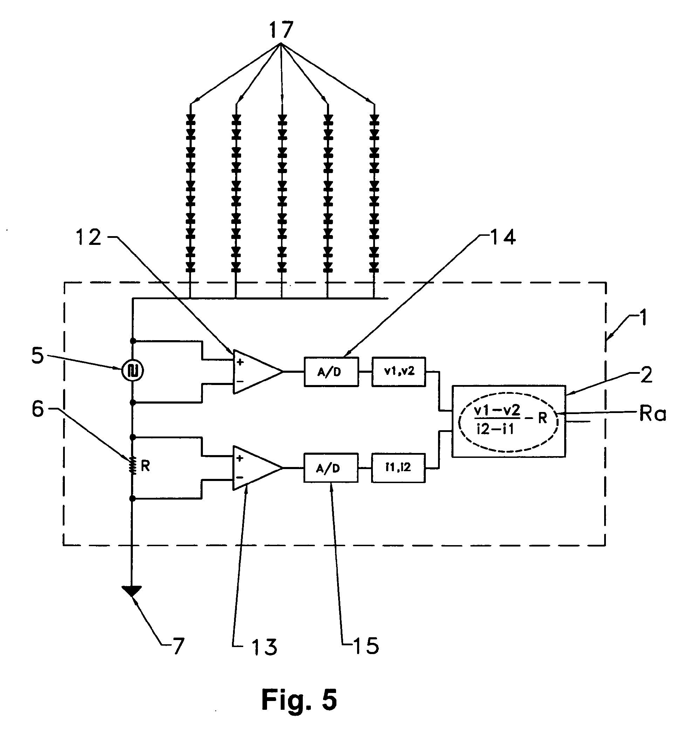

A particular application is illustrated in Figure 5, in which the dc source is connected to the node N1, and for which the Rᵢ to be measured is a panel of photovoltaic cells (17)(array).

## Claims

1. A process for measuring the electrical insulation resistance of a dc voltage source, such as a panel of photovoltaic cells (17) or other device for generating direct electrical current, **characterised in that** the dc voltage source is exposed simultaneously, in common mode, to at least two electrical voltage to earth (7) values.

2. A process for measuring the electrical insulation resistance of a dc voltage source, according to claim 1, **characterised in that** transducers (8, 9, 12, 13) are used to measure the current intensities (i₁, i₂) corresponding to the two common mode electrical voltage to earth (7) values (v₁, v₂) for the direct current source in question (16, 17).

3. A process for measuring the electrical insulation resistance of a dc voltage source, according to the preceding claims, **characterised in that**, by means of an analog-digital converter (10, 11, 14, 15), said voltage (v₁, v₂) and intensity (i₁, i₂) values are acquired by a computer (2) which, in accordance with a set algorithm, obtains an insulation resistance value (Rᵢ).

4. A process for measuring the electrical insulation resistance of a dc voltage source, according to the preceding claims, **characterised in that** said computer (2) ensures that acquisition of the voltage (v₁, v₂) and intensity (i₁, i₂) values takes place in real time.

5. A process for measuring the electrical insulation resistance of a dc voltage source, according to the preceding claims, **characterised in that** said computer (2) controls the moment of acquisition of the voltage (v₁, v₂) and intensity (i₁, i₂) values, either by controlling opening and closing of electronic switches (3, 4) which distinguish the circuit which at each moment is exposed to a common voltage to earth (7) value (v₁, v₂), or by means of constant clock pulse sources (5).

6. A process for measuring the electrical insulation resistance of a dc voltage source, according to the preceding claims, **characterised in that** the computer (2) acquires the voltage (v₁, v₂) and intensity (i₁, i₂) values with a certain delay with regard to the change from one to the other common voltage to earth (7) value (v₁, v₂), ensuring that the system has reached steady operating conditions.

7. A device for measuring the electrical insulation resistance of a dc voltage source, according to the preceding claims, **characterised in that** it consists of an electronic unit known as an insulation sensor (1) which has a connection to earth (7) and to one or more systems for generating dc voltage (16, 17), and whose insulation sensor (1) includes one or more transducers (8, 9, 12, 13) for measuring current intensity and/or voltage, a plurality of analog-digital converters (10, 11, 14, 15), and a computer (2) of the microprocessor type or the like.

8. A device for measuring the electrical insulation resistance of a dc voltage source, according to the preceding claims, **characterised in that** the insulation sensor (1) has: a plurality of electronic two-way switches (3, 4), first and second, which are interposed between the connection to earth (7) and the connections (N1, N2 etc.) to said systems for generating dc voltage (16, 17); a first voltage transducer (8) connected between an internal or external source for generating dc voltage (16, 17) and a first analog-digital voltage converter (10); a first intensity transducer (9) connected between a resistor (18) connected to earth (7) and a first analog-digital intensity converter (11); and a computer (2) which is connected to said first analog-digital voltage converter (10) and first analog-digital intensity converter (11).

9. A device for measuring the electrical insulation resistance of a dc voltage source, according to claims 1 to 7, **characterised in that**, irrespective of other external systems for generating dc voltage, the insulation sensor (1) includes: an auxiliary voltage pulse source (5) with constant clock times, which generates a square voltage wave of a certain frequency determined by the time constants which enable the system to reach its steady operating conditions; a shunt resistor, Rₛₕᵤₙₜ (6); a second voltage transducer (12) connected between the voltage pulse source (5) and a second analog-digital voltage converter (14); a second intensity transducer (13) connected between the shunt resistor, Rₛₕᵤₙₜ (6) and a second analog-digital intensity converter (15); and a computer (2) which is connected to said second analog-digital voltage converter (14) and second analog-digital intensity converter (15).
